# FASCICULE DE BREVET EUROPEEN

(11) **EP 4 121 711 B1**
(45) Date de publication et mention de la délivrance du brevet: **03.04.2024**
(21) Numéro de dépôt: 21712824.8
(22) Date de dépôt: 18.03.2021
(51) Int. Cl.: F28F 3/08, F28F 9/02, F28F 9/26, H01M 10/613, H01M 10/6556, H01M 10/6557, H01L 23/473, F28D 1/03

(54) **DISPOSITIF DE RÉGULATION THERMIQUE D'AU MOINS UN COMPOSANT ÉLECTRONIQUE**
VORRICHTUNG ZUR THERMISCHEN REGELUNG MINDESTENS EINES ELEKTRONISCHEN BAUTEILS
DEVICE FOR THERMAL REGULATION OF AT LEAST ONE ELECTRONIC COMPONENT

(30) Priorité: 20.03.2020 FR 2002732
(43) Date de publication de la demande: 25.01.2023
(73) Titulaire: VALEO SYSTEMES THERMIQUES, 78320 Le Mesnil Saint-Denis (FR)
(72) Inventeur: JOVET, Bastien, 78322 Le Mesnil-Saint-Denis Cedex (FR); IBRAHIMI, Mohamed, 78322 Le Mesnil-Saint-Denis Cedex (FR); PERRIN, Thibaut, 78322 Le Mesnil-Saint-Denis Cedex (FR)
(74) Mandataire: Valeo Systèmes Thermiques
(86) Numéro de dépôt international: PCT/EP2021/057004
(87) Numéro de publication internationale: WO 2021/185992

(56) Documents cités:
- EP-A2- 1 271 085
- WO-A1-2018/127639
- US-A1- 2007 039 717
- US-A1- 2017 352 934

## Description

La présente invention concerne les dispositifs de régulation thermique de composants électroniques, en particulier susceptibles de dégager de la chaleur en fonctionnement. En particulier, l'invention concerne la régulation thermique de tels composants qui ont besoin d'être maintenus dans une gamme de température donnée pour obtenir un fonctionnement et une durée de vie optimale. Il peut s'agir de cellules de stockage d'énergie électrique, de composants d'électronique de puissance, de circuits intégrés, de serveurs, centres de données, ou autres, qui nécessitent une régulation thermique afin de les maintenir dans leur plage de température de fonctionnement.

US 2007/039717 A1 et EP 1 271 085 A2 divulguent des dispositifs selon le préambule de la revendication 1.

Les centres de données à travers le monde représentent actuellement 10% de la consommation mondiale en électricité. Du fait de la croissance de la technologie de stockage et de transmission d'informations par "chaînes de blocs" (Blockchain en anglais) et l'avènement de la technologie de télécommunication 5G, ce pourcentage pourrait augmenter drastiquement dans les prochaines années. La moitié au moins de cette consommation provient de systèmes de refroidissement de ces centres de données. Actuellement la majorité des centres de données sont refroidies par air en refroidissant l'air ambiant des salles de stockage par des dispositifs de climatisation. La température de fonctionnement optimale pour les centres de données est comprise entre 5°C et 40°C, plus particulièrement autour de 27°C.

L'invention peut également s'appliquer dans le domaine automobile. L'invention trouve une application avantageuse dans le domaine de la régulation thermique d'éléments de stockage d'énergie électrique, tels que des batteries de véhicules automobiles à motorisation électrique ou hybride. L'énergie électrique des véhicules à motorisation électrique et/ou hybride est fournie par une ou plusieurs batteries. Durant leur fonctionnement, les éléments de stockage d'énergie électrique tels que les batteries, sont amenés à chauffer et risquent ainsi de s'endommager. Les cellules de stockage d'énergie à haute densité telles que les batteries Li-ion ou Li-polymère ont idéalement besoin de fonctionner dans une plage de température entre 20°C et 40°C.

Une technique de charge, dite de charge rapide, a fait son apparition récemment. Elle consiste à charger les éléments de stockage d'énergie sous une tension et un ampérage élevés, en un temps réduit, notamment en un temps maximum d'une vingtaine de minutes. Cette charge rapide implique un dégagement de chaleur important des éléments de stockage d'énergie électrique qu'il convient de traiter.

Pour la régulation thermique, notamment le refroidissement, d'éléments de stockage d'énergie électrique, tels que des batteries, il est connu d'utiliser un dispositif de régulation thermique.

Selon une solution connue, le dispositif de régulation thermique comporte des plaques, par exemple des plaques de refroidissement intégrant des canaux de circulation d'un fluide caloporteur, tel qu'un liquide de refroidissement, agencées entre les éléments de stockage d'énergie électrique. Ces plaques sont brasées entre elles et éventuellement également brasées à des collecteurs d'entrée et de sortie du liquide de refroidissement. En particulier, lors de l'assemblage, de tels éléments de stockage d'énergie électrique par exemple et les paires de plaques sont empilées successivement.

Cependant, un tel assemblage n'offre aucune flexibilité de montage quant à l'insertion des éléments de stockage d'énergie à refroidir dans le dispositif de régulation thermique. En effet, après brasage, le dispositif de régulation thermique est figé, il n'y a aucune flexibilité dans l'axe de l'empilement. Il n'est donc pas possible d'assurer un contact thermique efficace entre un composant à réguler thermiquement et une plaque, par exemple de refroidissement.

L'invention a pour objectif de permettre une meilleure insertion dans le dispositif de régulation thermique des composants électroniques, tout en assurant une régulation thermique, tel qu'un refroidissement, efficace des composants électroniques susceptibles de dégager de la chaleur lors de leur fonctionnement. L'invention peut avantageusement être utilisée dans le domaine automobile, par exemple, pour réguler thermiquement des composants d'électronique de puissance ou des cellules de stockage d'énergie électrique, ou encore dans le domaine des centres de données pour réguler des serveurs.

À cet effet, l'invention a pour objet un dispositif de régulation thermique d'au moins un composant électronique, ledit dispositif comportant au moins deux conduits de circulation d'un fluide caloporteur, agencés selon un axe d'empilement, et au moins un collecteur de fluide caloporteur en communication fluidique avec les conduits de circulation. Selon l'invention, ledit au moins un collecteur de fluide caloporteur comporte :
a. au moins deux portions de connexion fluidique respectivement assemblées à une extrémité d'un conduit de circulation correspondant, les portions de connexion fluidique comportant respectivement au moins un collet bordant un orifice, et
b. au moins un connecteur creux interposé entre deux portions de connexion fluidique selon l'axe d'empilement, et comportant deux tronçons d'extrémité opposés, montés coulissants à l'intérieur des collets de deux portions de connexion fluidique en vis-à-vis.

Les tronçons d'extrémité forment des bourrelets qui assurent la fonction d'étanchéité dudit au moins un collecteur de fluide caloporteur.

De plus, les connecteurs creux étant interposés entre les portions de connexion fluidique, il n'y a pas de liaison mécanique directe entre les conduits de circulation et les connecteurs creux, ce qui permet d'assurer un déplacement relatif entre les collets et les connecteurs montés coulissants. Ceci apporte une flexibilité, une tolérance au montage dans le sens de l'empilement, qui permettent d'écarter les conduits de circulation de fluide caloporteur pour insérer les composants à réguler thermiquement entre eux et ensuite de comprimer l'ensemble lorsque les composants sont insérés. La compression assure en outre de garantir un contact thermique efficace entre les conduits de circulation et les composants électroniques à réguler thermiquement interposés.

Le dispositif de régulation thermique peut en outre comporter une ou plusieurs caractéristiques suivantes décrites ci-après, prises séparément ou en combinaison.

Selon un aspect, ledit au moins un collet d'une portion de connexion fluidique s'étend depuis ladite portion en direction d'une portion de connexion fluidique voisine selon l'axe d'empilement.

Les tronçons d'extrémité sont montés coulissants dans les collets entre une première position et une deuxième position. Lorsque les tronçons d'extrémité sont dans la première position, ledit au moins un collecteur est dans une position d'extension maximale. Lorsque les tronçons d'extrémité sont dans la deuxième position, ledit au moins un collecteur est dans une position de compression maximale

Selon un autre aspect, ledit au moins un connecteur creux est conformé de sorte que les tronçons d'extrémité sont toujours reçus à l'intérieur des collets.

Les collets peuvent présenter respectivement une butée contre laquelle un tronçon d'extrémité d'un connecteur creux peut venir en butée dans la première position.

Avantageusement, ledit au moins un connecteur creux est conformé pour ne pas bloquer l'écoulement du fluide caloporteur en sortie du conduit de circulation, même dans la deuxième position ou position de compression maximale dudit au moins un collecteur de fluide caloporteur.

En particulier, le connecteur creux est conformé de sorte que les tronçons d'extrémité ne sont pas agencés en regard des sorties de fluide caloporteur des conduits de circulation, dans la position de compression maximale dudit au moins un collecteur de fluide caloporteur.

Selon une autre option, les collets peuvent présenter une autre butée contre laquelle un tronçon d'extrémité d'un connecteur creux peut venir en butée dans la position de compression maximale dudit au moins un collecteur de fluide caloporteur.

Selon encore une autre option, la longueur dudit au moins un connecteur creux peut être adaptée de sorte que les tronçons d'extrémité ne peuvent pas être agencés en regard des sorties des conduits de fluide caloporteur, dans la position de compression maximale dudit au moins un collecteur de fluide caloporteur.

Ledit au moins un connecteur creux peut présenter une forme générale cylindrique, avec une portion centrale présentant un premier diamètre externe et les tronçons d'extrémité présentent un deuxième diamètre externe supérieur au premier diamètre externe. Le terme « externe » est défini par opposition au passage d'écoulement du fluide caloporteur à l'intérieur du connecteur creux lorsque le collecteur de fluide caloporteur est assemblé.

Le deuxième diamètre externe des tronçons d'extrémité est égal ou supérieur au diamètre interne des collets, de sorte à toujours assurer l'étanchéité.

Selon encore un autre aspect, ledit dispositif peut comporter un nombre prédéfini de demi-coquilles assemblées par paires à une extrémité d'un conduit de circulation associé, de façon à définir une portion de connexion fluidique dudit au moins un collecteur de fluide caloporteur.

Ledit au moins un connecteur creux est agencé entre deux paires de demi-coquilles.

Au moins une demi-coquille d'une paire comporte au moins un collet s'étendant en direction d'une demi-coquille d'une paire adjacente selon l'axe d'empilement.

Ledit au moins un collet est réalisé d'une seule pièce avec la demi-coquille.

Deux demi-coquilles en vis-à-vis de deux paires adjacentes présentent respectivement au moins un collet, et un connecteur creux est agencé entre les collets de demi-coquilles en vis-à-vis.

Les demi-coquilles d'une paire sont symétriques selon un plan de joint.

Selon un exemple, les portions de connexion fluidique peuvent être réalisées dans un premier matériau et ledit au moins un connecteur creux peut comprendre au moins un deuxième matériau compressible. Le premier matériau présente une rigidité supérieure audit au moins un deuxième matériau.

Selon un premier mode de réalisation, ledit au moins un connecteur creux est agencé de façon centrée par rapport aux extrémités des conduits de circulation.

Selon un deuxième mode de réalisation, ledit au moins un connecteur creux est agencé de façon excentrée par rapport aux extrémités des conduits de circulation.

Ledit au moins un connecteur creux peut être réalisé par surmoulage d'un insert.

En particulier, ledit au moins un connecteur creux peut comprendre au moins deux matériaux. Ledit au moins un connecteur creux peut comprendre un matériau au centre, par exemple le matériau de l'insert, et un matériau autour, par exemple pour le surmoulage. Le matériau au centre peut présenter une rigidité supérieure au matériau autour, qui peut être de type élastomère par exemple de façon non limitative du caoutchouc éthylène-propylène-diène monomère connu sous le sigle EPDM. On obtient ainsi un squelette au centre plus rigide que la partie externe compressible, permettant d'éviter que le connecteur creux ne s'affaisse sur lui-même.

Selon une option, ledit au moins un collecteur de fluide caloporteur présente au moins une butée d'arrêt desdits composants selon un axe transversal à l'axe d'empilement.

Les demi-coquilles assemblées par paires présentent respectivement une bordure périphérique délimitant une ouverture dans laquelle débouche l'extrémité du conduit de circulation associé.

La bordure périphérique peut former ladite au moins une butée d'arrêt.

Ledit au moins un collecteur de fluide caloporteur peut être obturé d'un côté et raccordé à un circuit du fluide caloporteur de l'autre côté.

L'invention concerne par ailleurs un module de batterie pour véhicule automobile, comportant une pluralité de cellules de stockage d'énergie, et un dispositif de régulation thermique tel que défini précédemment, configuré pour réguler thermiquement les cellules de stockage d'énergie interposées entre les conduits de circulation de fluide caloporteur.

D'autres avantages et caractéristiques de l'invention apparaîtront plus clairement à la lecture de la description suivante donnée à titre d'exemple illustratif et non limitatif, et des dessins annexés parmi lesquels :
[Fig. 1] La figure 1 est une vue en perspective d'un dispositif de régulation thermique selon un premier mode de réalisation, assemblé avec des composants électroniques.
[Fig. 2] La figure 2 est une vue en perspective d'un dispositif de régulation thermique selon un deuxième mode de réalisation, assemblé avec des composants électroniques.
[Fig. 3] La figure 3 est une vue de dessus d'un dispositif de régulation thermique montrant un premier sens d'écoulement d'un fluide caloporteur au sein dudit dispositif.
[Fig. 4] La figure 4 est une vue de dessus d'un dispositif de régulation thermique montrant un deuxième sens d'écoulement d'un fluide caloporteur au sein dudit dispositif.
[Fig. 5] La figure 5 est une vue agrandie du collecteur de fluide caloporteur du dispositif de régulation thermique selon le premier mode de réalisation.
[Fig. 6] La figure 6 est une vue en coupe selon un axe d'empilement du collecteur de fluide caloporteur de la figure 5.
[Fig. 7] La figure 7 est une vue agrandie du collecteur de fluide caloporteur du dispositif de régulation thermique selon le deuxième mode de réalisation.
[Fig. 8] La figure 8 est une vue en coupe selon un axe d'empilement du collecteur de fluide caloporteur de la figure 7.
[Fig. 9] La figure 9 montre un exemple de réalisation d'un connecteur creux pour un collecteur de fluide caloporteur selon le premier ou le deuxième mode de réalisation.

Sur ces figures, les éléments identiques portent les mêmes numéros de référence.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées ou interchangées pour fournir d'autres réalisations.

Dans la description, on peut indexer certains éléments, comme par exemple premier élément ou deuxième élément. Dans ce cas, il s'agit d'un simple indexage pour différencier et dénommer des éléments proches mais non identiques. Cette indexation n'implique pas une priorité d'un élément par rapport à un autre et on peut aisément interchanger de telles dénominations sans sortir du cadre de la présente description. Cette indexation n'implique pas non plus un ordre dans le temps.

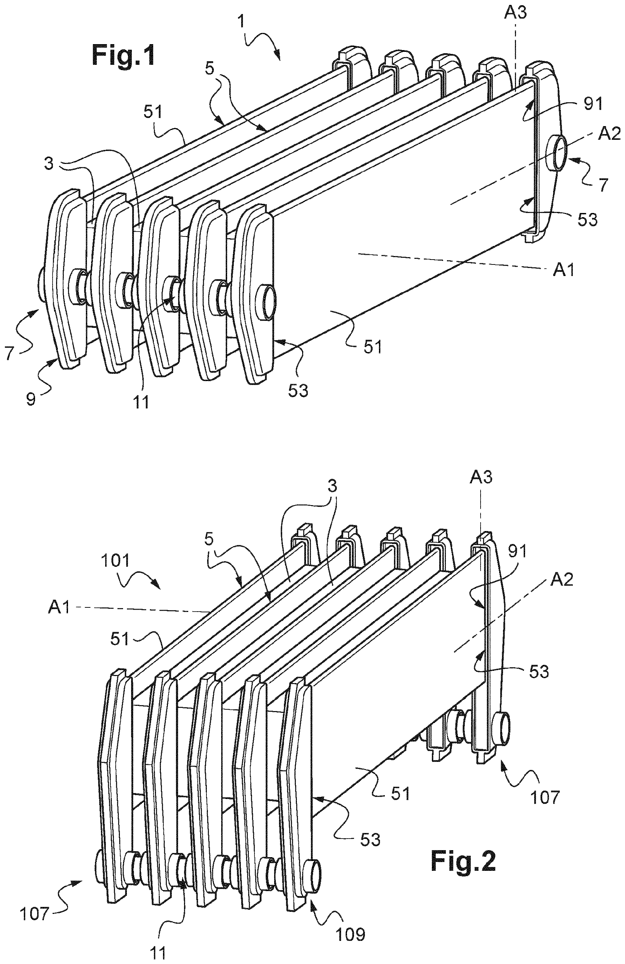

En référence aux figures 1 et 2 l'invention concerne un dispositif 1, 101 de régulation thermique. Un tel dispositif 1, 101 est notamment destiné à équiper un véhicule automobile. Le dispositif 1, 101 peut présenter une forme générale de parallélépipède.

Le dispositif 1, 101 est destiné à recevoir des composants 3 électroniques susceptibles de dégager de la chaleur lors de leur fonctionnement, pour la régulation thermique de ces derniers. De façon non exhaustive, les composants 3, représentés de façon très schématique sur les figures, peuvent notamment être des éléments de stockage d'énergie électrique ou un dispositif d'électronique de puissance, par exemple dans le domaine automobile. À titre d'exemple, il peut s'agir de cellules électriques composant un module de batterie ou pack batterie dans un véhicule électrique ou hybride.

La régulation thermique peut concerner le réchauffement et/ou le refroidissement des composants électroniques 3. En particulier, le dispositif 1, 101 de régulation thermique est configuré pour assurer une fonction de refroidissement des composants électroniques 3.

De façon générale, le dispositif 1, respectivement 101, comporte un nombre prédéfini de conduits 5 de circulation d'un fluide caloporteur et au moins un collecteur de fluide caloporteur 7, respectivement 107, en communication fluidique avec les conduits 5 de circulation. Le fluide caloporteur est par exemple un liquide de refroidissement. Dans les exemples illustrés, le dispositif 1, respectivement 101, comporte deux collecteurs de fluide caloporteur 7, respectivement 107, pour l'entrée et pour la sortie du fluide caloporteur.

Les conduits 5 sont agencés selon un axe d'empilement A1. Les composants 3 électroniques sont destinés à être interposés entre les conduits 5, de façon à former un empilement alterné de conduits 5 et de composants 3 selon l'axe d'empilement A 1.

Les conduits 5 de circulation sont par exemple formés par des tubes tels que des tubes extrudés. Les tubes extrudés présentent l'avantage de pouvoir être prévus ou coupés à la longueur souhaitée, par exemple de même longueur ou de longueur supérieure aux composants 3 électroniques associés. De plus, le nombre de tubes extrudés peut être adapté dans l'empilement, ce qui permet d'avoir un dispositif de régulation thermique 1, 101, modulaire.

De façon alternative, les conduits 5 peuvent être formés par l'assemblage de deux plaques, par exemple par brasage, délimitant entre elles au moins un canal pour la circulation du fluide caloporteur.

Le fluide caloporteur est destiné à s'écouler à l'intérieur d'un tube ou entre deux plaques, en une ou plusieurs passes, selon un schéma d'écoulement linéaire ou non, par exemple selon une circulation dite en « I » ou en deux passes pour une circulation dite en « U ».

Dans l'exemple particulier illustré sur la figure 1 ou 2, du dispositif 1, respectivement 101, les conduits 5 s'étendent par exemple suivant un plan perpendiculaire à l'axe d'empilement A1. Ils s'étendent longitudinalement selon un axe A2 qui est transversal à l'axe d'empilement A1, et s'étendent en largeur selon un axe A3, qui correspond à un axe vertical selon la disposition des éléments sur les figures 1 et 2.

Les conduits 5 présentent respectivement une paroi externe 51, c'est-à-dire opposée au canal de circulation du fluide caloporteur à l'intérieur du conduit 5. Cette paroi externe 51 est destinée à être agencée en contact thermique avec les composants 3 électroniques, lorsque le dispositif 1, respectivement 101, est monté par exemple dans un véhicule automobile.

Les parois externes 51 des conduits 5 peuvent être agencées en contact direct avec une surface du composant 3 électronique ou d'un support du composant 3 électronique. De façon alternative, une interface thermique (non représentée) peut être prévue entre chaque composant 3 électronique et les parois externes 51 de conduits 5 adjacents. En variante ou en complément, au moins un isolant électrique (non représenté) peut être prévu entre les composants 3 électroniques et les parois externes 51 de conduits 5 adjacents, afin de garantir la sécurité de l'utilisateur. L'isolation électrique peut être assurée par une couche de peinture. Selon une variante non représentée, l'isolant électrique et l'interface thermique peuvent être réalisés d'une seule pièce.

Comme dit précédemment, les conduits 5 de circulation de fluide caloporteur sont agencés en communication fluidique avec le ou les collecteurs de fluide caloporteur 7 ou 107. Pour ce faire, les conduits de circulation 5 comportent respectivement au moins une zone de connexion fluidique 53 à au moins l'un des collecteurs de fluide caloporteur 7 ou 107.

Les collecteurs de fluide caloporteur 7, respectivement 107, sont raccordés à une extrémité, ici une extrémité longitudinale, des conduits de circulation 5. Selon les modes de réalisation décrits avec deux collecteurs 7, respectivement 107, ils sont raccordés aux extrémités opposées des conduits de circulation 5. Les conduits de circulation 5 comportent dans ce cas deux zones de connexion fluidique 53, une à chaque extrémité, ici longitudinale. Les zones de connexion fluidique 53 des conduits de circulation 5 débouchent respectivement dans l'un des collecteurs de fluide caloporteur 7 ; 107.

De façon générale, les collecteurs de fluide caloporteur 7 ; 107 s'étendent longitudinalement selon l'axe d'empilement A1.

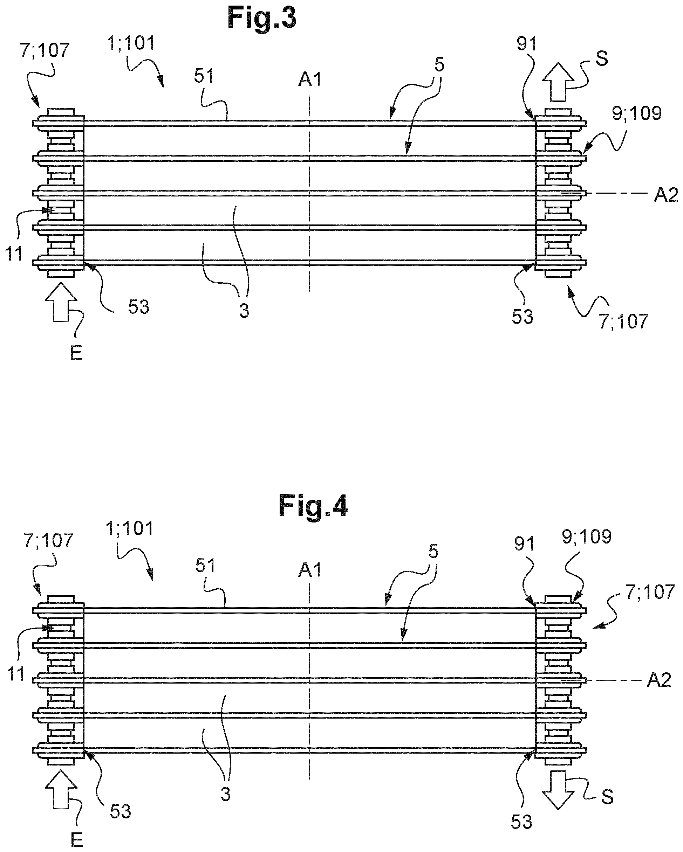

Par ailleurs, les collecteurs de fluide caloporteur 7 ; 107 sont obturés d'un côté et ouverts de l'autre côté de façon à être mis en communication fluidique avec un circuit du fluide caloporteur. Selon les exemples représentés sur les figures 3 et 4, il s'agit des côtés aux extrémités longitudinales des collecteurs de fluide caloporteur 7 ; 107 selon l'axe d'empilement A1.

L'un des collecteurs de fluide caloporteur 7 ; 107 permet l'entrée E du fluide caloporteur, par exemple froid, sa distribution dans les différents conduits de circulation 5, l'autre assure le retour et l'évacuation ou sortie S du fluide caloporteur, par exemple chaud, après passage de celui-ci dans les conduits de circulation 5.

Les deux collecteurs de fluide caloporteur 7 ; 107 pour l'entrée E de fluide caloporteur et la sortie S de fluide caloporteur, peuvent être ouverts et obturés de façon opposée, de façon à permettre l'entrée E et la sortie S du fluide caloporteur de deux côtés opposés du dispositif de régulation thermique 1 ; 101, comme schématisé sur la figure 3. À l'inverse, les deux collecteurs de fluide caloporteur 7 ; 107 peuvent être ouverts et obturés de façon symétrique par rapport à l'axe d'empilement A1, de façon à permettre l'entrée E et la sortie S du fluide caloporteur du même côté du dispositif de régulation thermique 1 ; 101, comme schématisé sur la figure 4.

De façon optionnelle, les collecteurs de fluide caloporteur 7 ou 107 peuvent éventuellement comprendre au moins une butée d'arrêt des composants 3 électroniques. Il s'agit en particulier d'une ou plusieurs butées d'arrêt permettant le blocage en position des composants 3 électroniques suivant l'axe transversal A2.

En référence aux figures 1 à 4, les collecteurs de fluide caloporteur 7, respectivement 107, présentent au moins deux portions de connexion fluidique 9 ; 109 et au moins un connecteur creux 11.

Le ou chaque connecteur creux 11 est interposé entre deux portions de connexion fluidique 9 ; 109 selon l'axe d'empilement A1. Plus globalement, selon les exemples illustrés, les collecteurs de fluide caloporteur 7, 107, présentent une succession alternée de portions de connexion fluidique 9 ; 109 et de connecteurs creux 11 interposés. Le collecteur de fluide caloporteur 7 ou 107 comporte avantageusement au moins un élément d'étanchéité entre les portions de connexion fluidique 9 ; 109 et les connecteurs creux 11.

Les portions de connexion fluidique 9 ; 109 sont agencées au niveau des zones de connexions fluidiques 53 des conduits de circulation 5. Les portions de connexion fluidique 9 ; 109 sont respectivement assemblées à une extrémité, ici une extrémité longitudinale selon l'axe transversal A2, d'un conduit de circulation 5 correspondant.

Pour ce faire, les portions de connexion fluidique 9 ; 109 délimitent respectivement au moins une ouverture 91 dans laquelle l'extrémité, ici longitudinale, d'un conduit de circulation 5 correspondant débouche à l'état assemblé du dispositif de régulation thermique 1 ; 101.

Une telle ouverture 91 est délimitée par une bordure périphérique qui peut former une butée d'arrêt pour les composants 3 selon l'axe transversal A2.

Le dimensionnement des portions de connexion fluidique 9 ; 109, tient compte notamment de contraintes mécanique internes, par exemple de la pression interne du fluide caloporteur, et externes au collecteur de fluide caloporteur 7 ; 107.

Les portions de connexion fluidique 9 ; 109 sont réalisées dans un premier matériau. En particulier, les portions de connexion fluidique 9 ; 109 peuvent être réalisées dans un matériau métallique, par exemple en aluminium ou en alliage d'aluminium. Les conduits 5 et les portions de connexion fluidique 9 ; 109 peuvent être brasés ensemble.

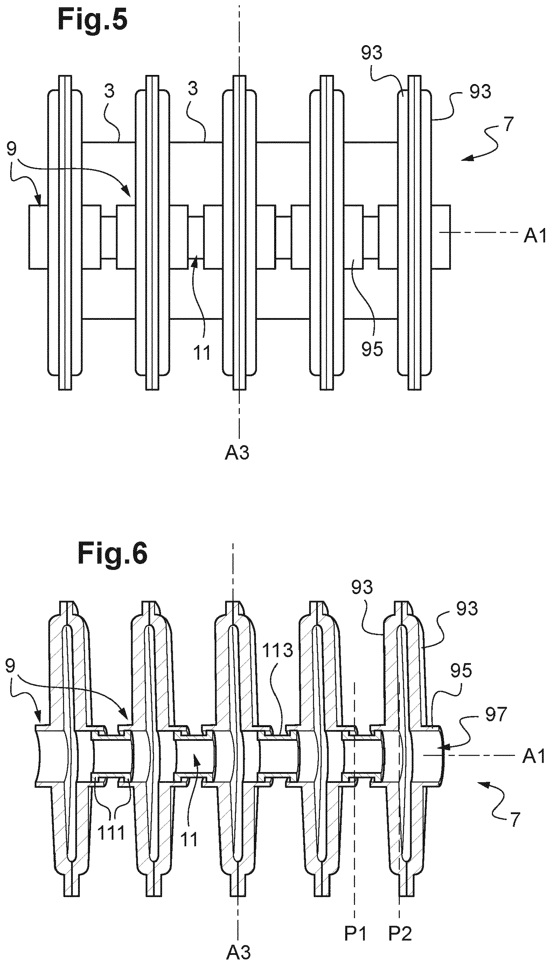

En référence aux figures 5 à 8, les portions de connexion fluidique 9 ; 109 peuvent par exemple être réalisées sous forme de demi-coquilles 93 assemblées par paires. Préférentiellement, les deux demi-coquilles 93 d'une paire sont symétriques par rapport à leur plan de joint.

Chaque paire de demi-coquilles 93 est agencée à une extrémité d'un conduit de circulation 5 correspondant. Les demi-coquilles 93 assemblées d'une paire définissent entre elles l'ouverture dans laquelle peut déboucher l'extrémité d'un conduit de circulation correspondant. La bordure périphérique des deux demi-coquilles 93 assemblées délimitant cette ouverture peut former la butée d'arrêt pour les composants 3 selon l'axe transversal A2.

Les demi-coquilles 93 peuvent être formées par emboutissage.

Les paires de demi-coquilles 93 sont mises en communication fluidique par les connecteurs creux 11 interposés, définissant ainsi un collecteur de fluide caloporteur 7 ou 107.

Les portions de connexion fluidique 9 ; 109 comportent de plus respectivement au moins un collet 95 bordant un orifice 97. Le collet 95 d'une portion donnée de connexion fluidique 9 ; 109 s'étend depuis cette dernière, en direction d'une portion de connexion fluidique voisine selon l'axe d'empilement A1. En particulier, le collet 95 s'étend depuis une surface externe de la portion donnée de connexion fluidique 9 ; 109, c'est-à-dire du côté opposé au passage d'écoulement du fluide caloporteur défini à l'intérieur de la portion de connexion fluidique 9 ; 109.

Les portions de connexion fluidique 9 ; 109 d'extrémité peuvent présenter un seul collet 95 ou deux collets 95 dont l'un est obturé. Les portions de connexion fluidique 9 ; 109 intermédiaires peuvent présenter deux collets 95 s'étendant respectivement en direction d'une portion de connexion fluidique 9 ; 109 voisine.

Selon l'exemple décrit précédemment, au moins l'une des demi-coquilles 93 d'une paire peut comporter un tel collet 95 bordant un orifice 97. Le collet 95 peut être venu de matière avec la demi-coquille 93.

Le collet 95 est orienté vers l'extérieur du passage d'écoulement de fluide caloporteur, défini entre les deux demi-coquilles 93 d'une même paire dans cet exemple. Le collet 95 d'une demi-coquille 93 s'étend en direction d'une demi-coquille 93 d'une paire adjacente ou voisine. Deux demi-coquilles 93 en vis-à-vis de deux paires voisines présentent respectivement un collet 95 en regard l'un de l'autre.

Le collet 95 d'une demi-coquille 93 d'extrémité, selon l'axe d'empilement A1, peut s'étendre par exemple en direction d'un élément de raccordement (non représenté) à un circuit du fluide caloporteur, tel qu'une tubulure. La demi-coquille 93 située à l'autre extrémité du collecteur de fluide caloporteur 7 ; 107 peut être dépourvue de collet ou présenter un collet obturé.

Les collets 95 sont de forme complémentaire à la forme des connecteurs creux 11. Les sont collets 95 sont par exemple de forme générale cylindrique. L'axe de révolution de la forme cylindrique est confondu avec l'axe d'empilement A1 à l'état assemblé du dispositif de régulation thermique. L'ensemble des collets 95 et des connecteurs creux 11 forment un cylindre du collecteur de fluide caloporteur 7 ; 107.

Les connecteurs creux 11 quant à eux sont réalisés par des rapportées distinctes des portions de connexion fluidique 9 ; 109 par exemple formées par les paires de demi-coquilles 93. Les connecteurs creux 11 sont par exemple sous forme de manchons.

Avantageusement, les connecteurs creux 11 comportent respectivement au moins un élément d'étanchéité.

Le connecteur creux 11 peut comprendre au moins un deuxième matériau compressible tel qu'un polymère, en particulier un élastomère. Un tel matériau compressible peut assurer la fonction d'un joint d'étanchéité. Le premier matériau des portions de connexion fluidique 9 ; 109 présente une rigidité supérieure à la rigidité du deuxième matériau.

Les connecteurs creux 11 sont respectivement agencés entre deux paires de demi-coquilles 93 de façon à mettre en communication fluidique les conduits de circulation 5. En particulier, les collets 95 des portions de connexion fluidique 9 ; 109 voisines, dans cet exemple des demi-coquilles 93 en vis-à-vis de paires voisines, sont assemblés par l'intermédiaire des connecteurs creux 11.

Les connecteurs creux 11 peuvent être emmanchés à l'intérieur des collets 95 des portions de connexion fluidique 9 ; 109.

Pour ce faire, les connecteurs creux 11 sont de forme complémentaire à celle des collets 95, par exemple de forme générale cylindrique dont l'axe de révolution est confondu avec l'axe d'empilement A1.

En référence aux figures 6, 8 et 9, les connecteurs creux 11 comportent respectivement deux tronçons d'extrémité 111 opposés, chacun étant destiné à être reçu dans un collet 95 complémentaire d'une portion de connexion fluidique 9 ; 109. Les tronçons d'extrémité 111 forment des bourrelets qui assurent la fonction d'étanchéité du collecteur de fluide caloporteur 7 ; 107. Chaque connecteur creux 11 présente ainsi deux éléments d'étanchéité de chaque côté.

Ces tronçons d'extrémité 111 sont situés de part et d'autre d'une portion centrale 113 selon l'axe d'empilement A1. La portion centrale 113 présente un premier diamètre externe d1 et les tronçons d'extrémité 111 présentent un deuxième diamètre externe d2 supérieur au premier diamètre externe d1. Le terme « externe » est défini par opposition au passage d'écoulement du fluide caloporteur à l'intérieur du connecteur creux 11 lorsque le collecteur de fluide caloporteur 7 ; 107 est assemblé.

Le deuxième diamètre externe d2 des tronçons d'extrémité 111 est égal ou supérieur au diamètre interne du collet 95 le recevant, de façon à garantir l'étanchéité.

De plus, les tronçons d'extrémité 111 des connecteurs creux 11 sont montés coulissants dans les collets 95, de façon à permettre un déplacement relatif entre les collets 95 et les connecteurs creux 11. Un tel déplacement offre une tolérance au montage suivant l'axe d'empilement A1. En effet, cela permet d'écarter ou étirer le collecteur de fluide caloporteur 7 ; 107 ou au contraire de le comprimer dans l'axe d'empilement A1. Ceci confère une flexibilité au dispositif 1, 101 selon l'axe d'empilement A1, et autorise d'écarter les conduits de circulation 5 pour insérer les composants 3 électroniques à réguler thermiquement entre eux et ensuite de comprimer l'empilement des conduits de circulation 5 avec les composants 3 électroniques interposés.

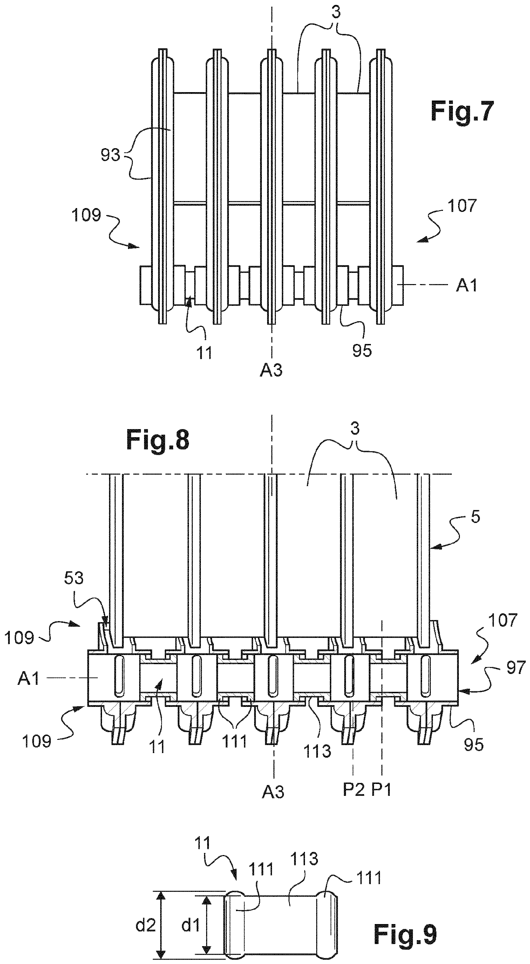

Plus précisément, les tronçons d'extrémité 111 sont montés coulissants entre une première position délimitée à titre d'exemple non limitatif par un trait discontinu référencé P1 sur les figures 6 et 8, et une deuxième position délimitée à titre d'exemple non limitatif par un trait discontinu référencé P2 sur les figures 6 et 8. Ces deux positions P1 et P2 définissent des positions extrêmales entre lesquelles un tronçon d'extrémité 111 peut coulisser.

Lorsque les tronçons d'extrémité 111 des connecteurs creux 11 sont dans la première position P1, le collecteur de fluide caloporteur 7 ; 107 est dans une configuration ou position d'extension maximale. À l'inverse, lorsque les tronçons d'extrémité 111 des connecteurs creux 11 sont dans la deuxième position P2, le collecteur de fluide caloporteur 7 ; 107 est dans une configuration ou position de compression maximale.

Le connecteur creux 11 est avantageusement conformé de sorte que les tronçons d'extrémité 111 du connecteur creux sont reçus à l'intérieur des collets 95 dans toutes les positions.

Dans la première position P1, les tronçons d'extrémités 111, en particulier au niveau de la jonction avec la portion centrale 113, peuvent venir en appui contre des premières butées (non représentées sur les figures) prévues au niveau des collets 95. Ceci permet d'empêcher que les tronçons d'extrémité 111 ne sortent à l'extérieur des collets 95 et que les connecteurs creux 11 ne soient désolidarisés des portions de connexion fluidique 9 ; 109.

En outre, les connecteurs creux 11 sont avantageusement conformés pour ne pas bloquer l'écoulement du fluide caloporteur en sortie du conduit de circulation, même dans la position de compression maximale du collecteur de fluide caloporteur 7 ; 107. En particulier, les connecteurs creux 11 sont conformés de sorte que leurs tronçons d'extrémité 111 ne viennent pas en regard des sorties des conduits de fluide caloporteur 5, lorsque le collecteur de fluide caloporteur 7 ; 107 est dans la position de compression maximale.

Pour ce faire, dans la deuxième position P2, les tronçons d'extrémité 111, en particulier du côté opposé à la portion centrale 113, peuvent venir en appui contre des deuxièmes butées (non représentées sur les figures) prévues au niveau des collets 95.

En alternative ou en complément, la longueur des connecteurs d'extrémité 11 peut être adaptée de sorte que les tronçons d'extrémité 111 ne peuvent pas être agencés en regard des sorties de fluide caloporteur des conduits de circulation 5, même lorsque le collecteur de fluide caloporteur 7 ; 107 est dans la position de compression maximale.

De plus, les connecteurs creux 11 peuvent être réalisés par surmoulage d'inserts. Cela revient notamment à surmouler deux joints d'étanchéité (formés par les tronçons d'extrémité 111) en une seule pièce.

Les connecteurs creux 11 peuvent comprendre par exemple au moins deux matériaux, dont le deuxième matériau compressible. Les deux matériaux d'un connecteur creux 11 peuvent être de rigidité différente, de souplesse différente.

Selon un exemple non limitatif, les connecteurs creux 11 peuvent comprendre un matériau au centre, par exemple le matériau de l'insert, entouré par un autre matériau, tel que le deuxième matériau compressible. Il s'agit dans cet exemple du matériau pour le surmoulage. Le matériau au centre peut être un troisième matériau présentant une rigidité supérieure à celle du deuxième matériau compressible autour. Ce dernier peut être de type élastomère, par exemple de façon non limitative de l'éthylène-propylène-diène monomère connu sous le sigle EPDM. L'insert sert de squelette permettant d'éviter que le connecteur creux 11 ne s'affaisse sur lui-même.

Deux modes de réalisation des collecteurs de fluide caloporteur 7 ; 107 sont représentés.

Selon un premier mode de réalisation illustré sur les figures 1, 5 et 6, les connecteurs creux 11 sont agencés de façon centrée par rapport aux extrémités des conduits de circulation 5.

De façon complémentaire, les portions de connexion fluidique 9 ; 109, par exemple sous forme de paires de demi-coquilles 93, sont centrées par rapport aux extrémités des conduits de circulation 5, en particulier selon l'axe A3. Les collets 95 peuvent être au centre des demi-coquilles 93, en particulier selon l'axe A3. De plus, les demi-coquilles 93 peuvent présenter une largeur selon l'axe A3 qui peut être légèrement supérieure à la largeur des extrémités longitudinales des conduits de circulation 5.

Selon un deuxième mode de réalisation représenté sur les figures 2, 7 et 8, les connecteurs creux 11 sont agencés de façon excentrée par rapport aux extrémités des conduits de circulation 5, en particulier selon l'axe A3. Autrement dit, la zone de jonction entre les portions de connexion fluidique 9 ; 109 est excentrée. Cette zone de jonction mécanique se retrouve dans une partie plus basse du dispositif de régulation thermique 1 ; 101 en référence à l'orientation des éléments sur les figures 2, 7 et 8.

De façon complémentaire, les portions de connexion fluidique 9 ; 109, par exemple sous forme de paires de demi-coquilles 93 sont excentrées par rapport aux extrémités des conduits de circulation 5. De plus, les demi-coquilles 93 peuvent présenter une largeur selon l'axe A3 supérieure à la largeur des extrémités longitudinales des conduits de circulation 5.

Ainsi, les conduits de circulation 5 peuvent être assemblés aux portions de connexion fluidique 9 ; 109, par exemple sous forme de paires de demi-coquilles 93, par exemple par brasage. Les portions de connexion fluidique 9 ; 109 dans lesquelles débouchent les extrémités des conduits de circulation 5, peuvent être assemblées aux connecteurs creux 11 de façon à former un collecteur de fluide caloporteur 7 ; 107 selon l'un ou l'autre des modes de réalisation.

Cette opération peut se faire pour les deux collecteurs de fluide caloporteur 7 ; 107 de façon à former le dispositif 1 ; 101 de régulation thermique. Les collecteurs de fluide caloporteur 7 ; 107 obtenus par l'assemblage des portions de connexion fluidique 9 ; 109 aux connecteurs creux 11 peuvent être les mêmes quels que soient les dimensions notamment l'épaisseur, la configuration, le nombre, des composants 3 électroniques à réguler thermiquement.

Cet assemblage peut se faire de sorte que les conduits de circulation 5 sont avantageusement espacés selon l'axe d'empilement A1, d'un écart prédéfini, qui peut être standard. De façon à permettre l'insertion des composants 3 électroniques à réguler thermiquement, cet écart prédéfini est supérieur à la dimension de ces composants 3 dans l'axe d'empilement A1.

Les tronçons d'extrémité 111 des connecteurs creux 11 peuvent coulisser à l'intérieur des collets 95 complémentaires jusqu'à atteindre la première position P1 ou une autre position intermédiaire entre les positions extrêmes P1 et P2. Les connecteurs creux coulissent vers l'extérieur des portions de connexion fluidique 9 ; 109, vers l'extérieur de l'espace pour l'écoulement du fluide caloporteur défini entre deux demi-coquilles 93 d'une paire par exemple. Avant compression, le collecteur de fluide caloporteur 7 ; 107 est dans une position étendue voire d'extension maximale.

Le dispositif 1 ; 101 de régulation thermique peut par exemple être livré à un client final, tel qu'un constructeur automobile, avant assemblage avec les composants 3 électroniques à réguler thermiquement.

Ensuite, les composants 3 électroniques peuvent être insérés simultanément, ou en alternative un à un, entre les conduits de circulation 5.

Par la suite, l'ensemble peut être comprimé selon l'axe d'empilement A1, de préférence des deux côtés du dispositif 1 ; 101, du fait de la flexibilité des collecteurs de fluide caloporteur 7 ; 107 en faisant coulisser les tronçons d'extrémité 111 des connecteurs 11 dans les collets 95 associés. Cette fois, les tronçons d'extrémité 111 coulissent vers l'intérieur des portions de connexion fluidique 9 ; 109, vers l'intérieur de l'espace pour l'écoulement du fluide caloporteur défini entre deux demi-coquilles 93 d'une paire par exemple.

Les tronçons d'extrémité 111 des connecteurs creux 11 peuvent coulisser à l'intérieur des collets 95 complémentaires jusqu'à atteindre la deuxième position P2. Le collecteur de fluide caloporteur 7 ; 107 se retrouve dans un état comprimé, autrement dit, les portions de connexion fluidique 9 ; 109 sont plus resserrées, plus rapprochées, par rapport à la position étendue ou d'extension maximale.

Cette compression assure le maintien en position des composants 3 électroniques entre les conduits de circulation 5, et permet de garantir le contact thermique nécessaire à la régulation thermique tel que le refroidissement. Cela permet de se passer ou de réduire la quantité d'interface thermique comme une pâte thermique entre les composants 3 à refroidir et les conduits de circulation 5. Toutefois, une interface thermique (non représentée) peut éventuellement être prévue entre les composants 3 électroniques et les conduits de circulation 5.

Enfin, en complément de la compression de l'ensemble après insertion des composants 3 électroniques entre les conduits de circulation 5, la bordure périphérique des portions de connexion fluidique 9 ; 109 délimitant l'ouverture dans laquelle débouche l'extrémité du conduit de circulation 5 correspondant peut former la butée d'arrêt pour les composants 3 électroniques selon l'axe transversal A2.

Le dispositif de régulation thermique 1 ; 101 ainsi assemblé aux composants 3 électroniques à réguler thermiquement forme un module tel qu'un module de batterie pour véhicule automobile, en particulier électrique ou hybride.

## Revendications

1. Dispositif (1 ; 101) de régulation thermique d'au moins un composant (3) électronique, ledit dispositif (1 ; 101) comportant au moins deux conduits de circulation (5) d'un fluide caloporteur, agencés selon un axe d'empilement (A1), et au moins un collecteur de fluide caloporteur (7 ; 107) en communication fluidique avec les conduits de circulation (5), ledit au moins un collecteur de fluide caloporteur (7 ; 107) comporte :
- au moins deux portions de connexion fluidique (9 ; 109), respectivement assemblées à une extrémité d'un conduit de circulation (5) correspondant, les portions de connexion fluidique (9 ; 109) comportant respectivement au moins un collet (95) bordant un orifice (97), et **caractérisé en ce que** le collecteur comporte
- au moins un connecteur creux (11) interposé entre deux portions de connexion fluidique selon l'axe d'empilement (A1), et comportant deux tronçons d'extrémité (111) opposés, montés coulissants à l'intérieur des collets (95) de deux portions de connexion fluidique (9 ; 109) en vis-à-vis.

2. Dispositif (1 ; 101) selon la revendication précédente, dans lequel ledit au moins un connecteur creux (11) présente une forme générale cylindrique, avec une portion centrale (113) présentant un premier diamètre externe (d1) et les tronçons d'extrémité (111) présentent un deuxième diamètre externe (d2) supérieur au premier diamètre externe (d1).

3. Dispositif (1 ; 101) selon la revendication précédente, dans lequel le deuxième diamètre externe (d2) des tronçons d'extrémité (111) est égal ou supérieur au diamètre interne des collets (95).

4. Dispositif (1 ; 101) selon l'une des revendications précédentes,
dans lequel ledit au moins un collet (95) d'une portion de connexion fluidique (9 ; 109) s'étend depuis ladite portion (9 ; 109) en direction d'une portion de connexion fluidique voisine selon l'axe d'empilement (A1).

5. Dispositif (1 ; 101) selon l'une des revendications précédentes, comportant un nombre prédéfini de demi-coquilles (93) assemblées par paires à une extrémité d'un conduit de circulation associé, de façon à définir une portion de connexion fluidique dudit au moins un collecteur de fluide caloporteur, et dans lequel ledit au moins un connecteur creux est agencé entre deux paires de demi-coquilles.

6. Dispositif (1 ; 101) selon l'une des revendications précédentes,
dans lequel les portions de connexion fluidique (9 ; 109) sont réalisées dans un premier matériau et ledit au moins un connecteur creux (11) comprend au moins un deuxième matériau compressible, le premier matériau présentant une rigidité supérieure audit au moins un deuxième matériau.

7. Dispositif (1) selon l'une des revendications 1 à 6, dans lequel ledit au moins un connecteur creux (11) est agencé de façon centrée par rapport aux extrémités des conduits de circulation (5).

8. Dispositif (101) selon l'une des revendications 1 à 6, dans lequel ledit au moins un connecteur creux est agencé de façon excentrée par rapport aux extrémités des conduits de circulation (5).

9. Dispositif (1 ; 101) selon l'une des revendications précédentes, dans lequel le connecteur creux (11) est réalisé par surmoulage d'un insert.

10. Dispositif (1 ; 101) selon l'une des revendications précédentes,
dans lequel ledit au moins un collecteur de fluide caloporteur (7 ; 107) présente au moins une butée d'arrêt desdits composants selon un axe transversal (A2) à l'axe d'empilement (A1).

## Patentansprüche

1. Vorrichtung (1; 101) zur thermischen Regelung wenigstens eines elektronischen Bauteils (3), wobei die Vorrichtung (1; 101) wenigstens zwei Durchströmungsleitungen (5) für ein Wärmeübertragungsfluid, die entlang einer Stapelungsachse (A1) angeordnet sind, und wenigstens einen Wärmeübertragungsfluid-Endboden (7; 107) in Fluidverbindung mit den Durchströmungsleitungen (5) aufweist,
wobei der wenigstens eine Wärmeübertragungsfluid-Endboden (7; 107) Folgendes aufweist:
- wenigstens zwei Fluidverbindungsabschnitte (9; 109), die jeweils an einem Ende einer entsprechenden Durchströmungsleitung (5) angebracht sind, wobei die Fluidverbindungsabschnitte (9; 109) jeweils wenigstens einen Kragen (95) aufweisen, der eine Öffnung (97) einfasst, und **dadurch gekennzeichnet, dass** der Endboden Folgendes aufweist
- wenigstens ein hohles Verbindungsstück (11), das entlang der Stapelungsachse (A1) zwischen zwei Fluidverbindungsabschnitten angeordnet ist und zwei gegenüberliegende Endabschnitte (111) aufweist, die innerhalb der Kragen (95) zweier Fluidverbindungsabschnitte (9; 109) gegenüberliegend gleitend gelagert sind.

2. Vorrichtung (1; 101) nach dem vorhergehenden Anspruch, wobei das wenigstens eine hohle Verbindungsstück (11) eine allgemein zylindrische Form aufweist, mit einem Mittelabschnitt (113), der einen ersten Außendurchmesser (d1) aufweist, und die Endabschnitte (111) einen zweiten Außendurchmesser (d2) aufweisen, der größer als der erste Außendurchmesser (d1) ist.

3. Vorrichtung (1; 101) nach dem vorhergehenden Anspruch, wobei der zweite Außendurchmesser (d2) der Endabschnitte (111) gleich oder größer als der Innendurchmesser der Kragen (95) ist.

4. Vorrichtung (1; 101) nach einem der vorhergehenden Ansprüche, wobei sich der wenigstens eine Kragen (95) eines Fluidverbindungsabschnitts (9; 109) von dem Abschnitt (9; 109) in Richtung eines benachbarten Fluidverbindungsabschnitts entlang der Stapelungsachse (A1) erstreckt.

5. Vorrichtung (1; 101) nach einem der vorhergehenden Ansprüche, die eine vorgegebene Anzahl von Halbschalen (93) aufweist, die paarweise an einem Ende einer zugehörigen Durchströmungsleitung angebracht sind, so dass ein Fluidverbindungsabschnitt des wenigstens einen Wärmeübertragungsfluid-Endbodens definiert wird, und wobei das wenigstens eine hohle Verbindungsstück zwischen zwei Halbschalenpaaren angeordnet ist.

6. Vorrichtung (1; 101) nach einem der vorhergehenden Ansprüche, wobei die Fluidverbindungsabschnitte (9; 109) aus einem ersten Material gebildet sind und das wenigstens eine hohle Verbindungsstück (11) wenigstens ein zweites, zusammendrückbares Material umfasst, wobei das erste Material eine höhere Steifigkeit als das wenigstens eine zweite Material aufweist.

7. Vorrichtung (1) nach einem der Ansprüche 1 bis 6, wobei das wenigstens eine hohle Verbindungsstück (11) im Verhältnis zu den Enden der Durchströmungsleitungen (5) zentriert angeordnet ist.

8. Vorrichtung (101) nach einem der Ansprüche 1 bis 6, wobei das wenigstens eine hohle Verbindungsstück im Verhältnis zu den Enden der Durchströmungsleitungen (5) exzentrisch angeordnet ist.

9. Vorrichtung (1; 101) nach einem der vorhergehenden Ansprüche, wobei das hohle Verbindungsstück (11) durch Überformung eines Einsatzes gebildet ist.

10. Vorrichtung (1; 101) nach einem der vorhergehenden Ansprüche, wobei der wenigstens eine Wärmeübertragungsfluid-Endboden (7; 107) wenigstens einen Anschlag für die Bauteile entlang einer Querachse (A2) zur Stapelungsachse (A1) aufweist.

## Claims

1. Device (1; 101) for thermally regulating at least one electronic component (3), said device (1; 101) having at least two circulation ducts (5) for a heat transfer fluid which are arranged along a stacking axis (A1), and at least one heat transfer fluid manifold (7; 107) in fluidic communication with the circulation ducts (5), said at least one heat transfer fluid manifold (7; 107) has:
- at least two fluidic connection portions (9; 109) respectively assembled at one end of a corresponding circulation duct (5), the fluidic connection portions (9; 109) respectively having at least one collar (95) bordering an orifice (97), and **characterized in that** the manifold has
- at least one hollow connector (11) interposed between two fluidic connection portions along the stacking axis (A1), and having two opposite end sections (111) mounted so as to be able to slide inside the collars (95) of two facing fluidic connection portions (9; 109).

2. Device (1; 101) according to the preceding claim, wherein said at least one hollow connector (11) has a cylindrical overall shape, with a central portion (113) having a first external diameter (d1) and the end sections (111) having a second external diameter (d2) greater than the first external diameter (d1).

3. Device (1; 101) according to the preceding claim, wherein the second external diameter (d2) of the end sections (111) is equal to or greater than the internal diameter of the collars (95).

4. Device (1; 101) according to one of the preceding claims, wherein said at least one collar (95) of a fluidic connection portion (9; 109) extends from said portion (9; 109) toward a neighbouring fluidic connection portion along the stacking axis (A1).

5. Device (1; 101) according to one of the preceding claims, having a predefined number of half-shells (93) assembled in pairs at one end of an associated circulation duct, so as to define a fluidic connection portion of said at least one heat transfer fluid manifold, and wherein said at least one hollow connector is arranged between two pairs of half-shells.

6. Device (1; 101) according to one of the preceding claims, wherein the fluidic connection portions (9; 109) are made from a first material and said at least one hollow connector (11) comprises at least one second, compressible material, the first material having a greater stiffness than said at least one second material.

7. Device (1) according to one of Claims 1 to 6, wherein said at least one hollow connector (11) is arranged centrally with respect to the ends of the circulation ducts (5).

8. Device (101) according to one of Claims 1 to 6, wherein said at least one hollow connector is arranged eccentrically with respect to the ends of the circulation ducts (5).

9. Device (1; 101) according to one of the preceding claims, wherein the hollow connector (11) is made by overmoulding an insert.

10. Device (1; 101) according to one of the preceding claims, wherein said at least one heat transfer fluid manifold (7; 107) has at least one end stop for said components along an axis (A2) transverse to the stacking axis (A1).
